**Europäisches Patentamt**

**European Patent Office**

**Office européen des brevets**

(11) Publication number: **0 026 788**
**B1**

(12) **EUROPEAN PATENT SPECIFICATION**

(45) Date of publication of patent specification: **30.12.86**

(51) Int. Cl.⁴: **H 01 L 23/12**

(21) Application number: **80900500.2**

(22) Date of filing: **29.02.80**

(86) International application number:
**PCT/JP80/00036**

(87) International publication number:
**WO 80/01966 18.09.80 Gazette 80/21**

(54) **SEMICONDUCTOR DEVICE.**

(30) Priority: **09.03.79 JP 27303/79**

(43) Date of publication of application:
**15.04.81 Bulletin 81/15**

(45) Publication of the grant of the patent:
**30.12.86 Bulletin 86/52**

(84) Designated Contracting States:
**DE FR GB SE**

(56) References cited:
**GB-A-1 200 375**
**JP-B-49 005 386**
**JP-U-48 035 269**
**JP-Y-52 027 653**
**US-A-3 886 505**
**US-A-3 986 196**
**US-A-4 067 040**

**Denshi Zyiryo Vol. 14 No. 4 (1975-4) Kogyo Chosakai Fukuda Masumi, Ishikawa Hajime, "X Band koshutsuryoku GaAs FET to sono Zokusei" P. 79-84**

(73) Proprietor: **FUJITSU LIMITED**
**1015, Kamikodanaka Nakahara-ku**
**Kawasaki-shi Kanagawa 211 (JP)**

(72) Inventor: **HIRANO, Yutuka**
**13-16, Ohji 2-chome**
**Atsugi-shi Kanagawa 243 (JP)**

(74) Representative: **Muir, Ian R. et al**
**HASELTINE LAKE & CO. Hazlitt House**
**28 Southampton Buildings Chancery Lane**
**London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to a semi-conductor device, and particularly to the structure of the metallised layer to which a semi-conductor element of the device is bonded by brazing and to which a lead wire extending from said semi-conductor element is connected within a hollow hermetically sealing member.

Semi-Conductor devices which are composed of compound semi-conductor materials such as gallium/arsenic (GaAs) or indium/phosphor (InP) etc. have recently been expanding their field of application because of their capability of functioning in a higher frequency range than devices composed of silicon (Si).

In semi-conductor devices which are composed of compound semi-conductor materials such as GaAs or InP etc., the semi-conductor element consists of a compound semi-conductor substrate having semi-insulation characteristics with an active layer formed on the surface of said compound semi-conductor and having a device such as a Schottky barrier field-effect transistor structured in this layer. Therefore, such a semi-conductor device requires the disposition of an electrode on the active region at the surface of the semi-conductor element to enable connection to a reference potential, for example, to ground potential. The electrode of the semiconductor device for grounding is then connected, within a package housing the semiconductor device, via a lead wire to a metallised layer formed on the grounding electrode or on a substrate surface extending from said electrode.

Said semiconductor element is bonded by brazing using an adequate solder onto the metallised layer which is formed on the substrate surface within the package.

U.S. patent specifications 4,067,040 and 3,886,505 each disclose a semiconductor device having a semi-conductor element bonded to a metallised layer and having a lead wire extending from the element and connected to a metallised layer within a hermetically sealing member. In each case, however, the metallised layer to which the element is bonded is separate from the metallised layer to which the lead is connected and no problems arise with the lead connection as a result of flow of brazing material used in the bonding.

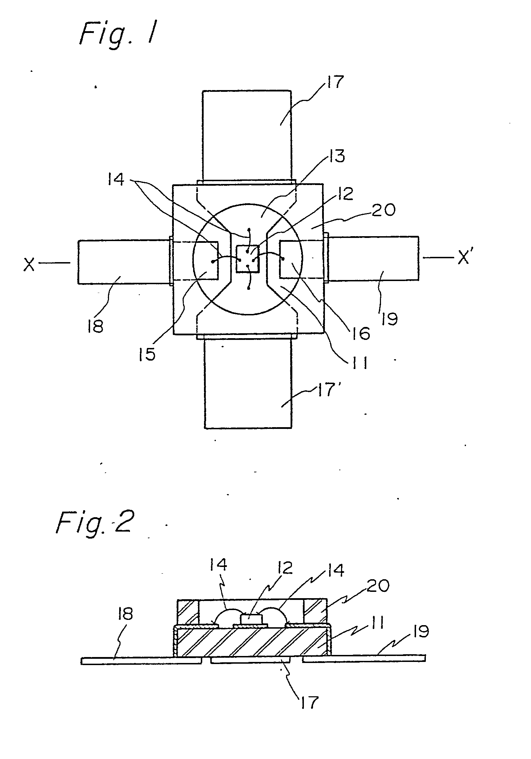

Figures 1 to 3 disclose the existing structure of a semiconductor device known to the applicant comprising a package which hermetically seals a microwave GaAs field effect transistor element composed of compound semiconductor materials.

In these Figures, 11 denotes an insulating substrate which is composed of a ceramic material such as alumina ($Al_2O_3$). On one main surface of the insulating substrate 11 a metallised layer is selectively formed which is basically composed of molybdenum (Mo) — manganese (Mn) or tungsten (W) with a surface plating of gold (Au). From the metallised layer are structured a metallised layer 13, on which a semiconductor element 12 is mounted and bonded, and the metallised layers 15 and 16 to which lead wires, for example gold lead wires 14, extending from electrodes of said semiconductor element 12 are connected.

Said metallised layers 13, 15 and 16 extend onto the other main surface of said insulating substrate 11 via the side surfaces of said insulating substrate 11 and external connecting terminals 17, 17', 18, 19 which are composed of kovar etc. are mounted and bonded by brazing onto said extended metallised layer areas.

In addition, on said one main surface of the insulating substrate 11, a frame 20 for hermetic sealing and consisting of ceramic material is arranged and bonded, surrounding the semiconductor element 12 and covering a part of the surface of said insulating substrate 11 and a part of the metallised layers 13, 15 and 16. Additionally, a cap (not illustrated) made of kovar or ceramic material is bonded to the frame 20 covering the aperture therein and thereby said semi-conductor element 12 bonded on the metallised layer 13 is hermetically sealed.

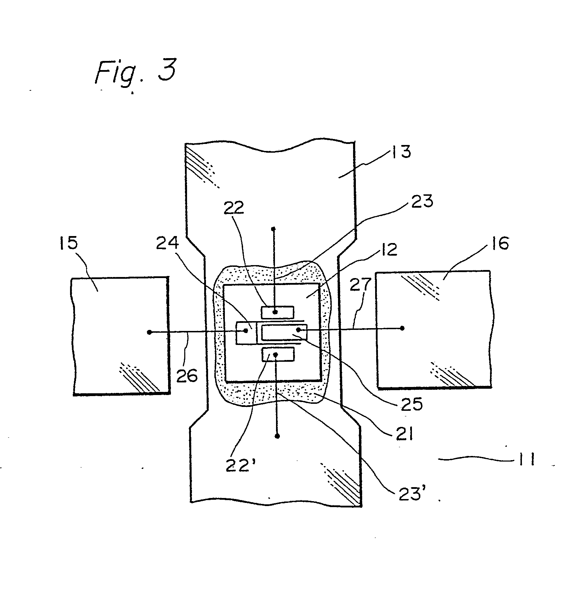

In a semi-conductor device having the above-mentioned structure, brazing material 21 of gold (Au)-tin(Sn) etc. is used for bonding the semiconductor element 12 onto the metallised layer 13 as shown in Fig. 3 in an enlarged view. At this time, as the brazing material 21 is melted, it readily flows over a wider area on the metallised layer 13 around the semi-conductor element 12.

Where it is necessary to connect an electrode of the semi-conductor element to the metallised layer 13, for example where the semi-conductor element is a GaAs field effect transistor and its source electrode is required to be grounded through connection to said metallised layer 13, then the lead wires 23, 23', extending from the source electrodes 22, 22' of the semi-conductor element 12 to the metallised layer 13 have to be extended and connected to said metallised layer 13, keeping away from the extensive brazing material 21.

In addition, exposure of such a semi-conductor device to a high temperature, after connection of such lead wires, can cause the spread of flowing brazing material 21 up to the connecting points of the lead wires 23, 23' to the metallised layer 13, thus resulting in a lowering of the bond strength of the lead wires and in some cases the disconnection of the lead wires.

In Fig. 3, 24 denotes a gate electrode forming an input electrode; 25 a drain electrode used as an output electrode; and 26, 27 lead wires for respectively connecting these electrodes and metallised layers 15, 16 for external connections. An attempt to prevent the above-mentioned phenomenon by making the connection of the lead wires 23, 23' to the metallised layer 13 sufficiently far from the bonding area of the semi-conductor element 12, results in the extension of the relevant metallised layer 13 and the insulation substrate 11, and a corresponding increase in the physical dimensions of the semi-conductor device.

The inventors have tried to completely isolate the metallised layer to which the lead wires are connected from the semi-conductor element in order to solve the above-mentioned problem, but such a construction makes it difficult to perform the gold plating processing of the metallised layer on which the semi-conductor element is bonded.

It is an object of the invention to provide a semi-conductor device which has a structure ensuring satisfactory connection of the lead wires to the metallised layer on which the semi-conductor element is mounted and bonded.

According to the present invention there is provided a semi-conductor device comprising an insulating substrate, an integral metallised layer formed on said substrate, a semi-conductor element bonded onto said integral metallised layer by means of brazing material, a lead wire extending from said semi-conductor element to said integral metallised layer, and a hollow hermetically sealing member having an inner wall disposed around said semi-conductor element with the lead wire being connected to said metallised layer inside this inner wall, wherein a non-metallised region is provided as a separation area between the semi-conductor element bonding area of the integral metallised layer and the lead wire connection area of the metallised layer whereby flow of brazing material from the semi-conductor bonding area of the layer to the layer/lead connection is obstructed.

Therefore, brazing material is blocked from flowing into the lead wire connecting part by means of the separation area and the hermetically sealing member at the time of connecting the lead wires to said metallised layer after a semi-conductor element has been bonded with brazing material onto the metallised layer. Thereby a simplification of lead wire connecting work and improvement in reliability of the connection may be realised.

For a better understanding of the present invention reference will now be made, by way of example, to the accompanying drawings in which:

Figure 1 is a plan view of an example of an existing semi-conductor device,

Figure 2 is a cross-section indicating a section along the line X—X' of the semi-conductor device shown in Fig. 1,

Figure 3 is a plan view diagrammatically showing the structure of a metallised layer, on which a semi-conductor element is bonded and to which lead wires extending from electrodes of said semi-conductor element are connected, in the semi-conductor device shown in Fig. 1,

Figure 4 is a plan view showing the pattern of a metallised layer, on which a semi-conductor element is bonded and to which lead wires extending from electrodes of said semi-conductor element are connected, in a first embodiment of a semi-conductor device of this invention,

Figure 5 is a plan view showing diagrammatically the structure of the first embodiment of a semi-conductor device in accordance with this invention,

Figure 6 is a plan view showing the pattern of a metallised layer, on which a semi-conductor element is bonded and to which lead wires extending from electrodes of said semi-conductor element are connected, in a second embodiment of a semi-conductor device in accordance with this invention, and

Figure 7 is a plan view indicating a structure of the second embodiment of the semi-conductor device of this invention.

The invention will be explained in detail hereunder by referring, by way of example, to two preferred embodiments.

Embodiment 1:

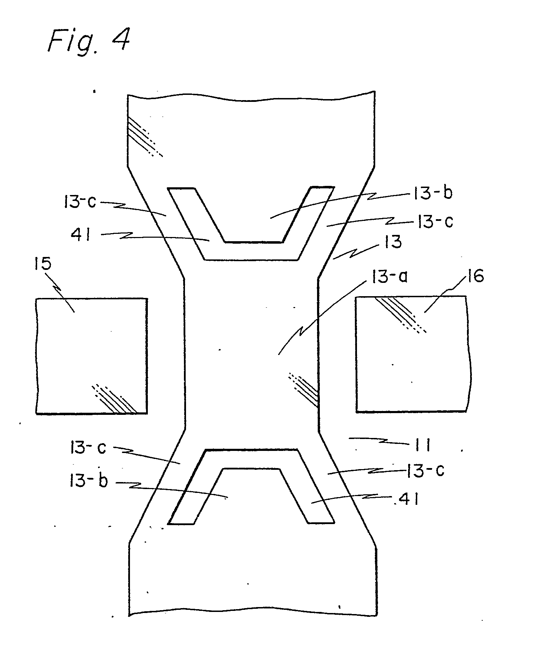

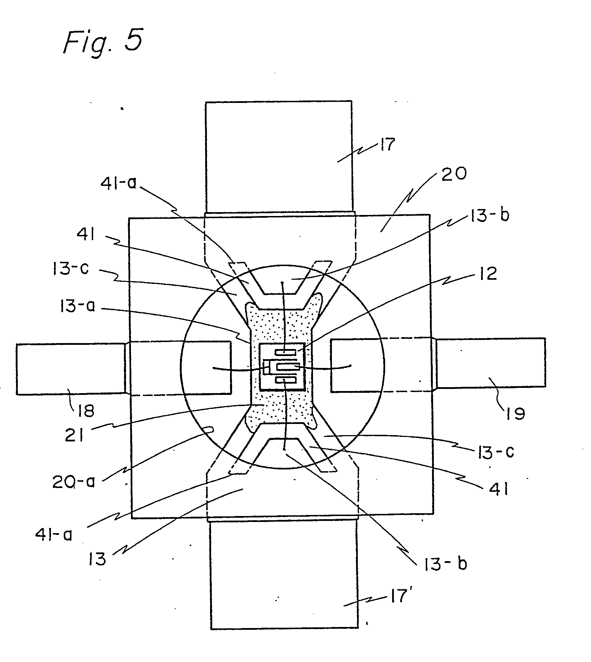

Figure 4 and Figure 5 show the first embodiment of a semi-conductor device in accordance with this invention. In these figures, the same or similar portions as those in the preceding Figures 1 to 3 are denoted by the same reference numerals. Figure 4 shows the pattern structure or form of the integral metallised layer in this embodiment of the invention, while Figure 5 shows in enlarged diagrammatic form a stage in the manufacture of the semi-conductor device at which a semi-conductor element 12 is mounted on a substrate within a hermetically sealing member of frame 20.

As shown in Fig. 4, in this embodiment of the invention, a separation area or region 41 consisting of a non-metallised layer, which separates said metallised layer 13 into an element bonding area 13-a and a lead wire connecting area 13-b, is formed in the metallised layer 13, composed of tungsten (W)-nickel (Ni)-gold(Au) and formed on the insulation substrate 11 composed of a ceramic material. A semi-conductor element 12 (Fig. 5) such as a GaAs field effect transistor etc., is bonded to the metallised layer on the area 13-a.

Selective formation of such a metallised layer may be realised by an ordinary silk screen method. As shown in the figure, said separation region 41 isolates the metallised layer 13 into the element bonding area 13-a and the lead wire connecting area 13-b only at the area adjacent to the semi-conductor element bonding area, and said metallised layer 13 is an integral layer and the separated areas join at the extended part where external connecting terminals are bonded.

In such a semi-conductor device structure, when a semi-conductor element is bonded onto the element bonding area 13-a of the metallised layer 13 using a brazing material such as gold-tin etc., even if the brazing material becomes fluid due to a temperature rise at the time of said bonding (heating up to about 290°C when gold-tin is used as the brazing material) or due to a succeeding temperature rise, for example, due to the heating for bonding the cap onto the hermetically sealing frame, the arrangement allows the brazing material to flow only to the metallised layer 13-c from said element bonding area 13-a and does not allow it to flow up to the lead wire connecting area 13-b of said metallised layer 13.

Therefore, the lead wires extending from an electrode (source electrode) of a semi-conductor element, for example a GaAs field effect transistor bonded on said element bonding area 13-a, can easily be connected to the lead wire connecting area 13-b and, moreover, a flow of the brazing material 21 will not result in deterioration of the strength of the connection of said lead wires or in their disconnection even if a temperature rise occurs after the assembling of said semi-conductor device.

In realising the preferred embodiment of this invention, the size of the aperture in the hermetically sealing frame 20, consisting of ceramic material (i.e. diameter of the circular aperture 20-a in the illustrated embodiment) and the size of the isolation region or separation area 41 are determined so that the internal wall of said frame 20 is positioned inside (the element side) of the external end 41-a of the separation area 41 provided in the metallised layer 13, as can be seen in Fig. 5. This structure can more effectively prevent the occurrence of trouble due to unwanted flow of said brazing material, as mentioned previously, because the flow of brazing material 21 along the metallised layer 13-c is impeded by the internal wall of said frame 20.

Embodiment 2:

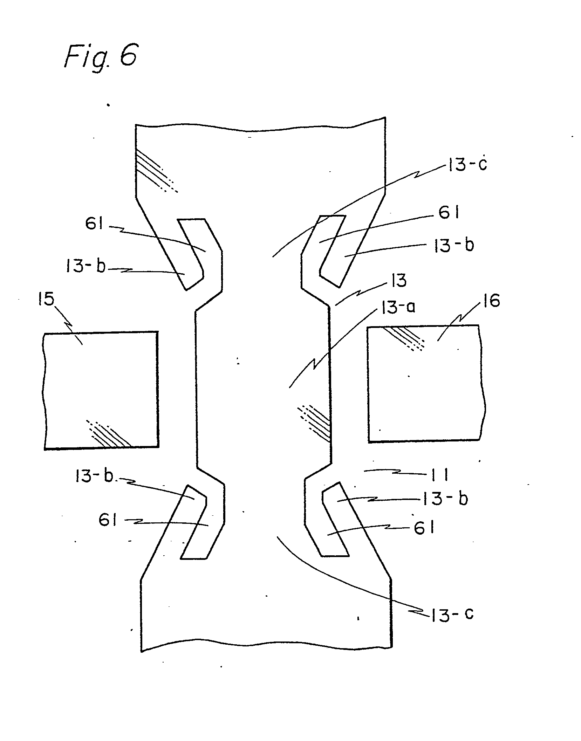

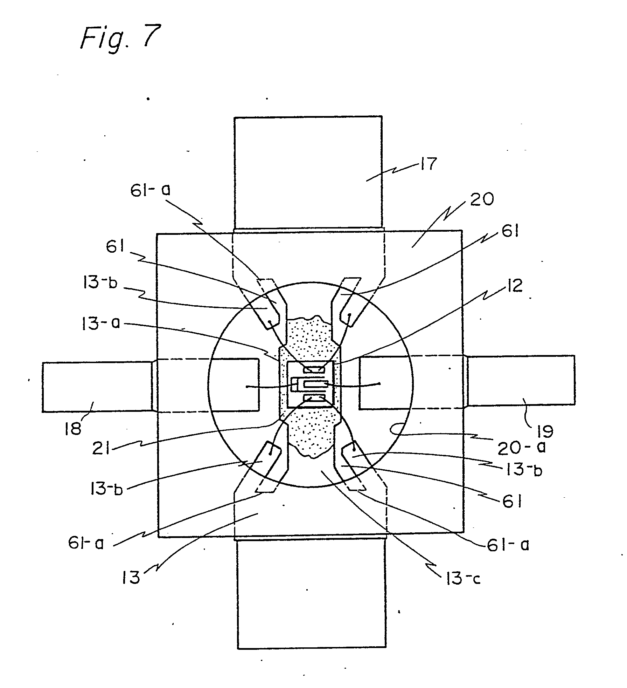

Figures 6 and 7 show the second embodiment of a semi-conductor device in accordance with this invention. In these figures, the parts the same as or similar to those in the previous Figures 1 to 5 are denoted by the same reference numerals. Figure 6 shows the pattern structure of a metallised layer used in the second embodiment of the invention, while Figure 7 shows the second embodiment semi-conductor device structure at the stage when a semi-conductor element and hermetically sealing frame etc. have been mounted.

As shown in Fig. 6, a semi-conductor device in this embodiment has four separation areas 61 consisting of non-metallised parts which separate the metallised layer 13, which is formed on the insulation substrate 11 into a bonding area 13-a and four lead connection areas 13-b, and facilitates bonding of a semi-conductor element 12, such as a GaAs field effect transistor, onto the element bonding area 13-a. As shown in the figure, the separation regions 61 isolate the integral metallised layer into the element bonding area 13-a and lead wire connecting areas 13-b only at the area adjacent to the semi-conductor element bonding area, and the element bonding area 13-a and the lead wire connecting areas 13-b join at an extending part of the layer where external connecting terminals are provided.

When a semi-conductor element is mounted onto the element bonding area 13-a of the metallised layer 13, using the brazing material 21 such as gold-tin etc., the illustrated structure allows the brazing material 21 to flow only to the metallised layer area 13-c from said element bonding area 13-a and not to flow up to the lead wire connection areas 13-b of the metallised layer 13.

Therefore, lead wires extending from a semi-conductor element, mounted on the element bonding area 13-a, can be connected easily to the lead wire connection areas 13-b, with no resulting deterioration of bond strength of the lead wire connection or of disconnection due to a flow of the brazing material 21 even if a temperature rise occurs after assembly of the semi-conductor device.

In realising the embodiment of the invention, the size of the aperture of the hermetically sealing frame 20 (diameter of the circular aperture 20-a in the illustrated embodiment) and size of the separation regions 61 are determined so that the internal wall of the frame 20 is positioned inside (the element side) of the end 61-a of the separation region 61 provided on the metallised layer 13. Such a structure blocks or impedes the flow of the brazing material 21 on the metallised layer 13-c by means of the internal wall of said frame 20, effectively preventing generation of trouble due to unwanted flow of the brazing material, as mentioned previously.

As explained above, by selecting the pattern structure of the metallised layer formed on the insulation substrate and the aperture size of the hermetically sealing member, flow of the fluid brazing material, up to the lead wire connecting area from the semi-conductor element part bonded on said metallised layer can be prevented successfully.

Therefore, connection of lead wires to the metallised layer can be made easily and with a high reliability, thereby improving reliability of the relevant semi-conductor device. Moreover, the semi-conductor bonding area and the lead wire connecting area of said metallised layer are very closely positioned on each side of the separation area and the semi-conductor can, therefore, be made very small in size.

In addition, the metallised layer in the present invention is an integral layer and not electrically separated into an element bonding area and a lead wire connecting area so that no disadvantage arises to the provision of gold plating on the layer surface.

**Claims**

1. A semi-conductor device comprising an insulating substrate (11), an integral metallised layer (13) formed on said substrate, a semi-conductor element (12) bonded onto said integral metallised layer (13) by means of brazing material (21), a lead wire (14) extending from said semi-conductor element (12) to said integral metallised layer, and a hollow hermetically sealing member (20) having an inner wall disposed around said semi-conductor element with the lead wire being connected to said metallised layer inside this inner wall, wherein a non-metallised region (41) is provided as a separation area between the semi-conductor element bonding area (13a) of the integral metallised layer and the lead wire connection area (13b) of the metallised layer whereby flow of brazing material from the semi-conductor bonding area (13a) of the layer to the layer/lead connection is obstructed.

2. A semi-conductor device as claimed in claim 1 wherein said sealing member comprises an insulating frame (20).

3. A semi-conductor device as claimed in claim 1 or claim 2 wherein the semi-conductor element (12) is a GaAs field effect transistor.

4. A semi-conductor device as claimed in claim 3 wherein the lead wire connected to the metallised layer extends from the source electrode of the GaAs field effect transistor (12).

5. A semi-conductor device according to claim 1 wherein the non-metallised region is substantially V- or U-shaped with the two legs of the V or U extending beyond said inner wall of the hollow sealing member (20) with the apex of the V or U being within the hollow member inner wall.

6. A semi-conductor device according to claim 1 wherein the non-metallised region extends from the periphery of the integral metallised layer within the inner wall of the hollow member (20) to a point beyond said inner wall.

**Revendications**

1. Dispositif semiconducteur comprenant un substrat isolant (11), une couche métallisée intégrale (13) formée sur ledit substrat, un élément semiconducteur (12) lié à la couche métallisée intégrale (13) à l'aide d'un matériau de soudage (21), un fil conducteur (14) s'étendant depuis ledit élément semiconducteur (12) jusqu'à ladite couche métallisée intégrale, et un élément d'étanchéité creux (20) possédant une paroi interne qui est disposée autour dudit élément semiconducteur de façon que le fil conducteur soit connecté à ladite couche métallisée à l'intérieur de cette paroi interne, où une région non métallisée (41) est prévue comme zone de séparation entre la zone (13-a) de liaison d'élément semiconducteur de la couche métallisée intégrale et la zone (13-b) de connexion de fils conducteurs de la couche métallisée, si bien que l'écoulement du matériau de soudage depuis la zone de liaison d'élément semiconducteur (13-a) de la couche jusqu'à la connexion couche-fils conducteurs rencontre un obstacle.

2. Dispositif semiconducteur selon la revendication 1, où ledit élément d'étanchéité comprend un cadre isolant (20).

3. Dispositif semiconducteur selon la revendication 1 ou 2, où l'élément semiconducteur (12) est un transistor à effet de champ de GaAs.

4. Dispositif semiconducteur selon la revendication 3, où le fil conducteur connecté à la couche métallisée s'étend depuis l'électrode de source du transistor à effet de champ de GaAs (12).

5. Dispositif semiconducteur selon la revendication 1, où la région non métallisée est sensiblement en forme de V ou en forme de U, les deux branches du V ou du U s'étendant au-delà de la paroi interne de l'élément d'étanchéité (20) de façon que le sommet du V ou du U se trouve à l'intérieur de la paroi interne de l'élément creux.

6. Dispositif semiconducteur selon la revendication 1, où la région non métallisée s'étend depuis la périphérie de la couche métallisée intégrale à l'intérieur de la paroi interne de l'élément creux (20) jusqu'en un point situé au-delà de ladite paroi interne.

**Patentansprüche**

1. Halbleitervorrichtung mit einem isolierenden Substrat (11), einer einstückigen metallisierten Schicht (13), die auf dem genannten Substrat gebildet ist, einem Halbleiterelement (12), welches mit der einstückigen metallisierten Schicht (13) mit Hilfe eines Lötmaterials (21) verbunden ist, einem Leitungsdraht (14), welcher sich von dem genannten Halbleiterelement (12) zu der einstückigen metallisierten Schicht erstreckt, und einem hohlen, hermetischen Versiegelungsteil (20), das eine innere Wand hat, die um das genannte Halbleiterelement angeordnet ist, wobei der Leitungsdraht mit der genannten metallisierten Schicht innerhalb dieser inneren Wand verbunden ist, bei welcher ein nichtmetallisierter Bereich (41) als ein Trennbereich zwischen dem Halbleiterelement-Verbindungsbereich (13a) der einstückigen metallisierten Schicht und dem Leitungsdraht-Verbindungsbereich (13b) der metallisierten Schicht vorgesehen ist, wodurch ein Fließen des Lötmaterials von dem Halbleiter-Verbindungsbereich (13a) der Schicht zu der Schicht/Leiter-Verbindung verhindert wird.

2. Halbleitervorrichtung nach Anspruch 1, bei welcher das Versiegelungsteil einen isolierenden Rahmen (20) umfaßt.

3. Halbleitervorrichtung nach Anspruch 1 oder 2, bei welcher das Halbleiterelement (12) ein GaAs-Feld-effekttransistor ist.

4. Halbleitervorrichtung nach Anspruch 3, bei welcher der Leitungsdraht, der mit der metallisierten Schicht verbunden ist, sich von der Sourceelektrode des GaAs-Feldeffekttransistors (12) erstreckt.

5. Halbleitervorrichtung nach Anspruch 1, bei welcher der nicht-metallisierte Bereich im wesentlichen V- oder U-förmig ist, wobei die beiden Schenkel des V oder U sich jenseits der genannten inneren Wand des hohlen Versiegelungsteils (20) erstrecken, wobei der Scheitelpunkt des V oder U innerhalb der inneren Wand des hohlen Teils ist.

6. Halbleitervorrichtung nach Anspruch 1, bei welcher der nicht-metallisierte Bereich sich von dem Umfang der einstückigen metallisierten Schicht innerhalb der inneren Wand des hohlen Teils (20) zu einem Punkt jenseits der inneren Wand erstreckt.

0 026 788

Fig. 1

Fig. 2

1

Fig. 3

## Fig. 4

*Fig. 5*

*Fig. 6*

Fig. 7